# EUROPEAN PATENT APPLICATION

(11) **EP 4 796 801 A1**
(43) Date of publication of application: **26.08.2026**
(21) Application number: 24895535.3
(22) Date of filing: 07.06.2024
(51) Int. Cl.: F16C 11/04, H04M 1/02

(54) **ROTATING SHAFT MECHANISM AND ELECTRONIC DEVICE**

(30) Priority: 27.11.2023 CN 202311598030
(71) Applicant: HUAWEI TECHNOLOGIES CO., LTD., Shenzhen 518129 (CN)
(72) Inventor: GAO, Guohui, Shenzhen, Guangdong 518129 (CN); ZHAN, Qiang, Shenzhen, Guangdong 518129 (CN); LIU, Yong, Shenzhen, Guangdong 518129 (CN)
(74) Representative: Gill Jennings & Every LLP
(86) International application number: PCT/CN2024/098199
(87) International publication number: WO 2025/112429

(57) **Abstract**

A hinge mechanism (1) and an electronic device are disclosed. The hinge mechanism (1) includes a first rotation module (112), a second rotation module (113), and a main shaft (111). The first rotation module (112) and the second rotation module (113) are separately disposed on two opposite sides of the main shaft (111). The first rotation module (112) includes a first door plate (1124) and a first arc arm (1121), at least a part of the first arc arm (1121) is disposed on a surface that is of the first door plate (1124) and that is away from a flexible display, and the first arc arm (1121) is rotatably connected to the main shaft (111). The first door plate (1124) is provided with at least two first limiting holes that are spaced apart in a first direction, a first connecting piece (1125) is disposed in the first limiting hole, and the first connecting piece (1125) is fastened to the first arc arm (1121). At least two first limiting layers (1126) that are spaced apart in the first direction are disposed between the first door plate (1124) and the first arc arm (1121), the first limiting layer (1126) and the first limiting hole are spaced apart in a second direction, and the first limiting layer (1126) is fastened to the first door plate (1124) and the first arc arm (1121).

## Description

### CROSS-REFERENCE TO RELATED APPLICATIONS

This application claims priority to Chinese Patent Application No. 202311598030.2, filed with the China National Intellectual Property Administration on November 27, 2023 and entitled "HINGE MECHANISM AND ELECTRONIC DEVICE", which is incorporated herein by reference in its entirety.

### TECHNICAL FIELD

This application relates to the field of electronic devices, and in particular, to a hinge mechanism and an electronic device.

### BACKGROUND

For an existing foldable electronic device, a screen crease and screen light and shadow are core competitiveness of a product, and are also a main bottleneck of the foldable electronic device currently. When the foldable electronic device is in a flattened state, a plane on which a screen is located may be referred to as a horizontal reference plane (horizontal plane for short). Screen light and shadow quality in a folding axis area is strongly correlated with an included angle between a door plate of a hinge module and the horizontal plane. If there is a relatively large included angle between the door plate and the horizontal plane, a local protrusion and a local depression may appear on the screen, directly causing deterioration of screen light and shadow.

A mounting surface of the door plate is usually a surface that is of an arc arm of the hinge module and that faces the screen. Due to impact of a movement gap and component size fluctuation, when the entire device is in the flattened state, there may be a relatively large included angle between the horizontal plane and the surface of the arc arm for mounting the door plate. As a result, there may be a relatively large included angle between the door plate and the horizontal plane, affecting screen light and shadow quality. Therefore, how to reduce the included angle between the door plate and the horizontal plane when the entire device is in the flattened state becomes a top priority for improving the screen light and shadow quality.

### SUMMARY

This application provides a hinge mechanism and an electronic device, to reduce an included angle between a door plate and a horizontal plane when an entire device is in a flattened state.

According to a first aspect, this application provides a hinge mechanism, used in a foldable electronic device. The hinge mechanism is disposed opposite to a foldable part of a flexible display of the electronic device, and the electronic device is unfolded or folded via the hinge mechanism. The hinge mechanism includes a first rotation module, a second rotation module, and a main shaft, and the first rotation module and the second rotation module are separately disposed on two opposite sides of the main shaft. The first rotation module includes a first door plate and a first arc arm, the first door plate is configured to support the flexible display, at least a part of the first arc arm is disposed on a surface that is of the first door plate and that is away from the flexible display, the first arc arm is rotatably connected to the main shaft, the first door plate is provided with at least two first limiting holes, the at least two first limiting holes are spaced apart in a first direction, a first connecting piece is disposed in the first limiting hole, the first connecting piece is fastened to the first arc arm to fasten the first door plate to the first arc arm, at least two first limiting layers are disposed between the first door plate and the first arc arm, the at least two first limiting layers are spaced apart in the first direction, the first limiting layer and the first limiting hole are spaced apart in a second direction, the first limiting layer is fastened to the first door plate and the first arc arm, the first direction is an axial direction of the hinge mechanism, the second direction is perpendicular to the first direction, and the second direction is perpendicular to a thickness direction of the hinge mechanism. The second rotation module includes a second door plate and a second arc arm, the second door plate is configured to support the flexible display, at least a part of the second arc arm is disposed on a surface that is of the second door plate and that is away from the flexible display, the second arc arm is rotatably connected to the main shaft, the second door plate is provided with at least two second limiting holes, the at least two second limiting holes are spaced apart in the first direction, a second connecting piece is disposed in the second limiting hole, the second connecting piece is fastened to the second arc arm to fasten the second door plate to the second arc arm, at least two second limiting layers are disposed between the second door plate and the second arc arm, the at least two second limiting layers are spaced apart in the first direction, the second limiting layer and the second limiting hole are spaced apart in the second direction, and the second limiting layer is fastened to the second door plate and the second arc arm.

In the technical solution provided in this application, the door plate and the arc arm are fastened by using a plurality of first connecting pieces and a plurality of first limiting layers. The plurality of first connecting pieces are spaced apart in the first direction, so that degrees of freedom of the door plate in the first direction and the second direction can be limited. The first limiting layer and the first limiting hole are spaced apart in the second direction, so that a degree of freedom of the door plate in a third direction can be limited. In this way, the door plate can be locked, to avoid displacement of the door plate relative to the arc arm in a process of unfolding or folding the entire device. In an assembly phase of the hinge mechanism, the first connecting piece limits the degrees of freedom of the door plate in the first direction and the second direction, and the door plate has a specific degree of freedom in the third direction, or the door plate has a specific degree of freedom of rotation. When the hinge mechanism is in a flattened state, an included angle between the door plate and a horizontal plane may be changed through matching with first limiting layers having different thicknesses, thereby overcoming an included angle difference between the horizontal plane and a surface of the arc arm for mounting the door plate, and reducing the included angle between the door plate and the horizontal plane when the entire device is in the flattened state, so that the included angle between the door plate and the horizontal plane is equal to or close to zero, and screen light and shadow quality of a folding axis area of the electronic device is improved.

In a specific implementation solution, the first limiting layer and the first limiting hole are staggered in the first direction; and the second limiting layer and the second limiting hole are staggered in the first direction. Degrees of freedom of the door plate in the first direction and the second direction can be stably limited, so that a position of the door plate is stable.

In a specific implementation solution, a part of the at least two first limiting holes is disposed close to an end of the first door plate in the first direction, and the other part of the first limiting holes is disposed close to the other end of the first door plate in the first direction; and a part of the at least two first limiting layers is disposed close to the end of the first door plate in the first direction, and the other part of the first limiting layers is disposed close to the other end of the first door plate in the first direction, so that degrees of freedom of the door plate in the first direction and the second direction can be stably limited. A part of the at least two second limiting holes is disposed close to an end of the second door plate in the first direction, and the other part of the second limiting holes is disposed close to the other end of the second door plate in the first direction; and a part of the at least two second limiting layers is disposed close to the end of the second door plate in the first direction, and the other part of the second limiting layers is disposed close to the other end of the second door plate in the first direction. Degrees of freedom of the door plate in the first direction and the second direction can also be stably limited.

In a specific implementation solution, the first door plate is provided with four first limiting holes, two of the four first limiting holes are disposed close to the end of the first door plate in the first direction, and the other two first limiting holes are disposed close to the other end of the first door plate in the first direction; and two first limiting layers are disposed between the first door plate and the first arc arm, one of the two first limiting layers is disposed close to the end of the first door plate in the first direction, and the other one first limiting layer is disposed close to the other end of the first door plate in the first direction. The second door plate is provided with four second limiting holes, two of the four second limiting holes are disposed close to the end of the second door plate in the first direction, and the other two second limiting holes are disposed close to the other end of the second door plate in the first direction; and two second limiting layers are disposed between the second door plate and the second arc arm, one of the two second limiting layers is disposed close to the end of the second door plate in the first direction, and the other one second limiting layer is disposed close to the other end of the second door plate in the first direction. The door plate can be fastened and horizontally disposed by using a relatively small quantity of first connecting pieces and first limiting layers.

In a specific implementation solution, for two first limiting holes and one first limiting layer that are disposed close to a same end of the first door plate in the first direction, the first limiting layer is located between the two first limiting holes in the first direction; and for two second limiting holes and one second limiting layer that are disposed close to a same end of the second door plate in the first direction, the second limiting layer is located between the two second limiting holes in the first direction. One first limiting layer and two first limiting holes may form a layout similar to a triangle, so that a fastened connection between the door plate and the arc arm can be stably maintained.

In a specific implementation solution, the first door plate is provided with two first limiting holes, one of the two first limiting holes is disposed close to the end of the first door plate in the first direction, and the other one first limiting hole is disposed close to the other end of the first door plate in the first direction; and four first limiting layers are disposed between the first door plate and the first arc arm, two of the four first limiting layers are disposed close to the end of the first door plate in the first direction, and the other two first limiting layers are disposed close to the other end of the first door plate in the first direction. The second door plate is provided with two second limiting holes, one of the two second limiting holes is disposed close to the end of the second door plate in the first direction, and the other one second limiting hole is disposed close to the other end of the second door plate in the first direction; and four second limiting layers are disposed between the second door plate and the second arc arm, two of the four second limiting layers are disposed close to the end of the second door plate in the first direction, and the other two second limiting layers are disposed close to the other end of the second door plate in the first direction. The door plate can be fastened and horizontally disposed by using a relatively small quantity of first connecting pieces and first limiting layers.

In a specific implementation solution, for one first limiting hole and two first limiting layers that are disposed close to a same end of the first door plate in the first direction, the first limiting hole is located between the two first limiting layers in the first direction; and for one second limiting hole and two second limiting layers that are disposed close to a same end of the second door plate in the first direction, the second limiting hole is located between the two second limiting layers in the first direction. One first limiting hole and two first limiting layers may form a layout similar to a triangle, so that a fastened connection between the door plate and the arc arm can be stably maintained.

In a specific implementation solution, a first protrusion is disposed on the surface that is of the first door plate and that is away from the flexible display, the first protrusion and the first limiting hole are spaced apart in the first direction, a first support surface is disposed on a surface that is of the main shaft and that faces the flexible display, the first support surface corresponds to the first protrusion in a third direction, the third direction is perpendicular to the first direction and the second direction, and when the electronic device is unfolded to a flattened state, an end that is of the first protrusion and that is away from the first door plate abuts against the first support surface. A second protrusion is disposed on the surface that is of the second door plate and that is away from the flexible display, the second protrusion and the second limiting hole are spaced apart in the first direction, a second support surface is disposed on the surface that is of the main shaft and that faces the flexible display, the second support surface corresponds to the second protrusion in the third direction, and when the electronic device is unfolded to the flattened state, an end that is of the second protrusion and that is away from the second door plate abuts against the second support surface. In an area that is of the door plate and that is not constrained by the first connecting piece and the first limiting layer, the first protrusion is disposed to increase limiting on the door plate in the third direction, and prop up the door plate, so as to prevent the door plate from collapsing due to factors such as deformation of the door plate and the gravity, and ensure that the door plate is horizontal.

In a specific implementation solution, the first protrusion is located between two adjacent first limiting holes in the first direction; and the second protrusion is located between two adjacent second limiting holes in the first direction. In an area that is of the door plate and that is not constrained by the first connecting piece and the first limiting layer, the first protrusion is disposed to increase limiting on the door plate in the third direction, so that a control area of the included angle between the door plate and the horizontal plane can be expanded.

In a specific implementation solution, a third protrusion is disposed on the surface that is of the first door plate and that is away from the flexible display, the third protrusion and the first limiting hole are spaced apart in the first direction, a first limiting claw is disposed at an end that is of the third protrusion and that is away from the first door plate, the first limiting claw extends in the second direction, a first limiting wall is disposed on the surface that is of the main shaft and that faces the flexible display, the first limiting wall corresponds to the first limiting claw in the third direction, the third direction is perpendicular to the first direction and the second direction, the first limiting wall extends in the second direction, the first limiting wall and the main shaft form a first limiting slot having a first opening, the first limiting claw extends into the first limiting slot through the first opening in a process of unfolding the electronic device, and when the electronic device is unfolded to the flattened state, the first limiting claw abuts against the first limiting wall. A fourth protrusion is disposed on the surface that is of the second door plate and that is away from the flexible display, the fourth protrusion and the second limiting hole are spaced apart in the first direction, a second limiting claw is disposed at an end that is of the fourth protrusion and that is away from the second door plate, the second limiting claw extends in the second direction, a second limiting wall is disposed on the surface that is of the main shaft and that faces the flexible display, the second limiting wall corresponds to the second limiting claw in the third direction, the second limiting wall extends in the second direction, the second limiting wall and the main shaft form a second limiting slot having a second opening, the second limiting claw extends into the second limiting slot through the second opening in the process of unfolding the electronic device, and when the electronic device is unfolded to the flattened state, the second limiting claw abuts against the second limiting wall. The first limiting claw and the first limiting slot are disposed to increase limiting on the door plate in the third direction, and hook the door plate, to prevent the door plate from tilting upward due to factors such as deformation of the door plate and an upward force applied by another component, and ensure that the door plate is horizontal.

In a specific implementation solution, the third protrusion is located between two adjacent first limiting holes in the first direction; and the fourth protrusion is located between two adjacent second limiting holes in the first direction. In an area that is of the door plate and that is not constrained by the first connecting piece and the first limiting layer, the first limiting claw and the first limiting slot are disposed to increase limiting on the door plate in the third direction, so that a control area of the included angle between the door plate and the horizontal plane can be expanded.

In a specific implementation solution, a third door plate is disposed on the surface that is of the main shaft and that faces the flexible display, the third door plate is configured to support the flexible display, the third door plate is located between the first rotation module and the second rotation module, and when the electronic device is unfolded to the flattened state, the third door plate, the first door plate, and the second door plate are located on a same plane. The third door plate, the first door plate, and the second door plate jointly support the flexible display, to improve flatness of the flexible display when the electronic device is in the flattened state, thereby improving screen light and shadow quality of the folding axis area of the electronic device.

According to a second aspect, this application further provides an electronic device, including a first housing, a second housing, a flexible display, and the hinge mechanism according to any one of the implementation solutions of the first aspect. The first housing and the second housing are separately disposed on two opposite sides of the hinge mechanism, the first housing is fastened to the first rotation module, and the second housing is fastened to the second rotation module. The flexible display continuously covers the first housing, the second housing, and the hinge mechanism, and the flexible display is fastened to the first housing and the second housing. Screen light and shadow quality of a folding axis area of the electronic device is high, so that use experience of the electronic device can be improved.

### BRIEF DESCRIPTION OF DRAWINGS

FIG. 1 is a diagram of a structure of a foldable electronic device according to an embodiment of this application;
FIG. 2 is a diagram of a partial structure of a hinge mechanism according to an embodiment of this application;
FIG. 3 is a diagram of a partial structure of a hinge mechanism in an unfolded state according to an embodiment of this application;
FIG. 4 is a diagram of a structure of a door plate of a hinge mechanism according to an embodiment of this application;
FIG. 5 is a diagram of a sectional structure of a door plate of a hinge mechanism according to an embodiment of this application;
FIG. 6 is a diagram of a manner of fastening a door plate of a hinge mechanism according to an embodiment of this application;
FIG. 7 is a diagram of a structure of a door plate of a hinge mechanism according to an embodiment of this application;
FIG. 8 is a diagram of a structure of a door plate of another hinge mechanism according to an embodiment of this application; and
FIG. 9 is a diagram of a structure of a hinge mechanism according to an embodiment of this application.

Reference numerals:
1: hinge mechanism; 1a: support surface of the hinge mechanism; 111: main shaft; 114: third door plate;
112: first rotation module; 1121: first arc arm; 1122: first support arm; 1123: first housing support;
1124: first door plate; 1125: first connecting piece; 1126: first limiting layer; 11241: first protrusion;
11242: first support surface; 11243: third protrusion; 11244: first limiting claw; 11245: first limiting wall;
11246: first limiting slot; 113: second rotation module; 1131: second arc arm; 1132: second support arm;
1133: second housing support; 1134: second door plate; 1135: second connecting piece; 1136: second limiting layer; and
2: first housing; 2a: support surface of the first housing; 3: second housing; 3a: support surface of the second housing.

### DESCRIPTION OF EMBODIMENTS

To make objectives, technical solution, and advantages of this application clearer, the following further describes embodiments of this application in detail with reference to the accompanying drawings. However, example implementations can be implemented in a plurality of forms, and should not be construed as being limited to the implementations described herein. Identical reference numerals in the accompanying drawings denote identical or similar structures. Therefore, repeated descriptions thereof are omitted. Expressions of positions and directions in embodiments of this application are described by using the accompanying drawings as an example. However, changes may be also made as required, and all the changes fall within the protection scope of this application. The accompanying drawings in embodiments of this application are merely used to illustrate relative position relationships and do not represent an actual scale.

Specific details are described in the following descriptions to facilitate understanding of this application. However, embodiments of this application can be implemented in a plurality of manners different from those described herein, and a person skilled in the art can perform similar promotion without departing from the connotation of embodiments of this application. Therefore, this application is not limited to the following disclosed specific implementations.

For ease of understanding, an application scenario of a hinge mechanism in this application is first described. The hinge mechanism provided in embodiments of this application may be adapted to an electronic device, for example, a mobile terminal like a mobile phone, a tablet computer, or a notebook computer. In a possible application scenario, the hinge mechanism provided in embodiments of this application may be adapted to a foldable electronic device, and is used as a component of a hinge module of the foldable electronic device.

The foldable electronic device usually includes mechanical parts such as a flexible display, the hinge module, and a housing. The housing includes a first housing and a second housing that are movably connected through the hinge module. When the entire foldable electronic device is unfolded or folded, the first housing and the second housing rotate relative to each other, the hinge module provides a damping force, and the flexible display is bent.

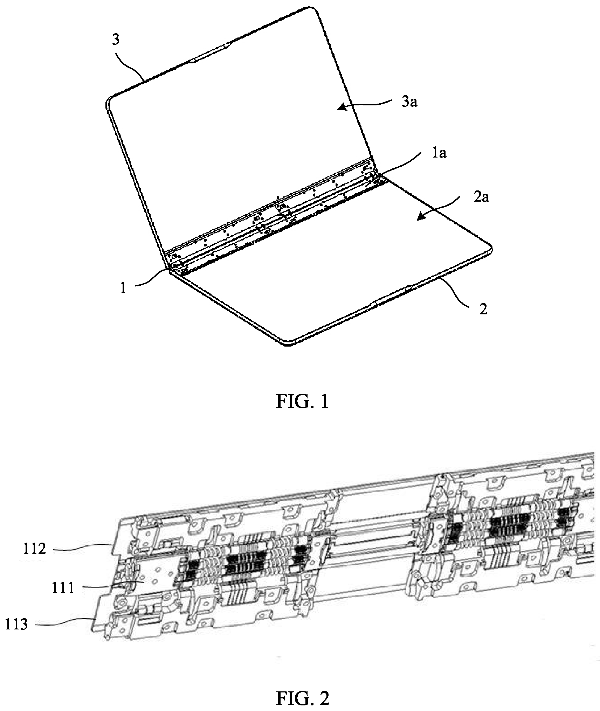

First, refer to FIG. 1. FIG. 1 is a diagram of a structure of a foldable electronic device according to an embodiment of this application. As shown in FIG. 1, the foldable electronic device provided in this embodiment of this application may include a hinge mechanism 1, a flexible display, and two housings. The hinge mechanism provided in embodiments of this application may be used as a component of the hinge mechanism 1. For ease of description, the two housings are respectively named a first housing 2 and a second housing 3. The first housing 2 and the second housing 3 are respectively located on two sides of the hinge mechanism 1 and can rotate around the hinge mechanism 1. During use, the electronic device may be folded or unfolded according to different use scenarios. The foldable electronic device provided in this embodiment of this application may be an inward foldable electronic device. In the embodiment shown in FIG. 1, the electronic device is in an intermediate state between a folded state and an unfolded state, and structures of a support surface 1a of the hinge mechanism 1, a support surface 2a of the first housing 2, and a support surface 3a of the second housing 3 are shown in the figure. Herein, the support surface 1a of the hinge mechanism 1 is a surface that is of the hinge mechanism 1 and that is configured to support the flexible display, the support surface 2a of the first housing 2 is a surface that is of the first housing 2 and that is configured to support the flexible display, and the support surface 3a of the second housing 3 is a surface that is of the second housing 3 and that is configured to support the flexible display.

The flexible display may continuously cover the support surface 2a of the first housing 2, the support surface 1a of the hinge mechanism 1, and the support surface 3a of the second housing 3, and the flexible display may be fastened to the support surface 2a of the first housing 2 and the support surface 3a of the second housing 3. A connection manner may be but is not limited to bonding. In this way, when the electronic device is in the unfolded state, the hinge mechanism 1, the first housing 2, and the second housing 3 can support the flexible display. In a process in which the first housing 2 and the second housing 3 rotate relative to each other from the unfolded state to the folded state or from the folded state to the unfolded state, the flexible display may be bent or flattened with the first housing 2 and the second housing 3.

Refer to FIG. 2. FIG. 2 is a diagram of a partial structure of a hinge mechanism according to an embodiment of this application. The hinge mechanism provided in this embodiment of this application may include a main shaft 111 and two rotation modules. The two rotation modules are a first rotation module 112 and a second rotation module 113. The main shaft 111 may be used as a bearing component of the first rotation module 112 and the second rotation module 113, and the first rotation module 112 and the second rotation module 113 are separately disposed on two opposite sides of the main shaft 111. When the entire electronic device is in a flattened state, the hinge mechanism is also in a flattened state. When the entire electronic device is in a folded state, the hinge mechanism is also in a folded state.

For ease of description, in the following embodiments of this application, a specific disposing manner of the first rotation module 112 is mainly used as an example to describe the hinge mechanism. For disposing of the second rotation module 113, refer to disposing of the first rotation module 112. It should be noted that a design of the second rotation module 113 may be completely consistent with that of the first rotation module 112. Alternatively, reference may be made to only components included in the first rotation module 112 and a connection relationship, and other parameters may be adaptively adjusted, and are not required to be completely consistent.

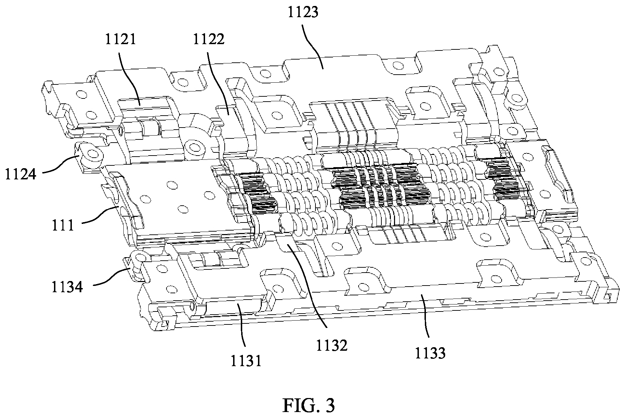

Refer to FIG. 3. FIG. 3 is a diagram of a partial structure of a hinge mechanism in an unfolded state according to an embodiment of this application. In this embodiment of this application, the first rotation module 112 may include a first arc arm 1121, a first support arm 1122, a first housing support 1123, and a first door plate 1124. The first door plate 1124 may be configured to support the flexible display, and is fastened to the flexible display. The first arc arm 1121 and the first support arm 1122 may be disposed on a surface that is of the first door plate 1124 and that is away from the flexible display. The first arc arm 1121 and the first support arm 1122 may be distributed in a length direction of the hinge mechanism, and may be rotatably connected to the main shaft 111. The first housing support 1123 may be located on a surface that is of the first arc arm 1121 and that is away from the first door plate 1124 and a surface that is of the first support arm 1122 and that is away from the first door plate 1124. The length direction of the hinge mechanism may be understood as an extension direction of an axis of rotation of the first housing 2 and the second housing 3 around the hinge mechanism. The length direction of the hinge mechanism may also be referred to as an axial direction of the hinge mechanism. For ease of description, the length direction of the hinge mechanism is referred to as a first direction. The first housing support 1123 may be configured to be fastened to the first housing, to implement a fastened connection between the first housing and the first rotation module 112. The first housing support 1123 may be rotatably connected to the first arc arm 1121 and slidably connected to the first support arm 1122. In a process of unfolding or folding the electronic device, the first housing support 1123 rotates synchronously with the first housing, to drive the first arc arm 1121 and the first support arm 1122 to rotate synchronously around the main shaft 111. In addition, the first door plate 1124 may be fastened to the first arc arm 1121, and the first door plate 1124 may rotate synchronously with the first arc arm 1121. Thus, in a rotation process of the first housing support 1123, the first door plate 1124 can also rotate according to a specific track, to provide flat support for the flexible display when the electronic device is in an unfolded state, and provide specific screen accommodating space for the flexible display when the electronic device is in a folded state, thereby ensuring reliability of the flexible display. Structural forms of the hinge mechanisms shown in FIG. 2 and FIG. 3 are merely examples, and are not intended to limit the solutions of this application. During practical application, a hinge mechanism in another structural form may be alternatively used.

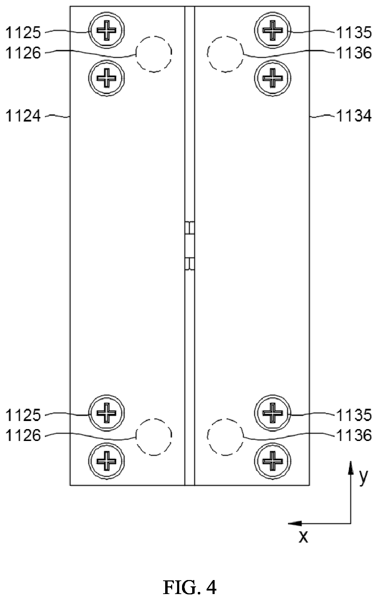

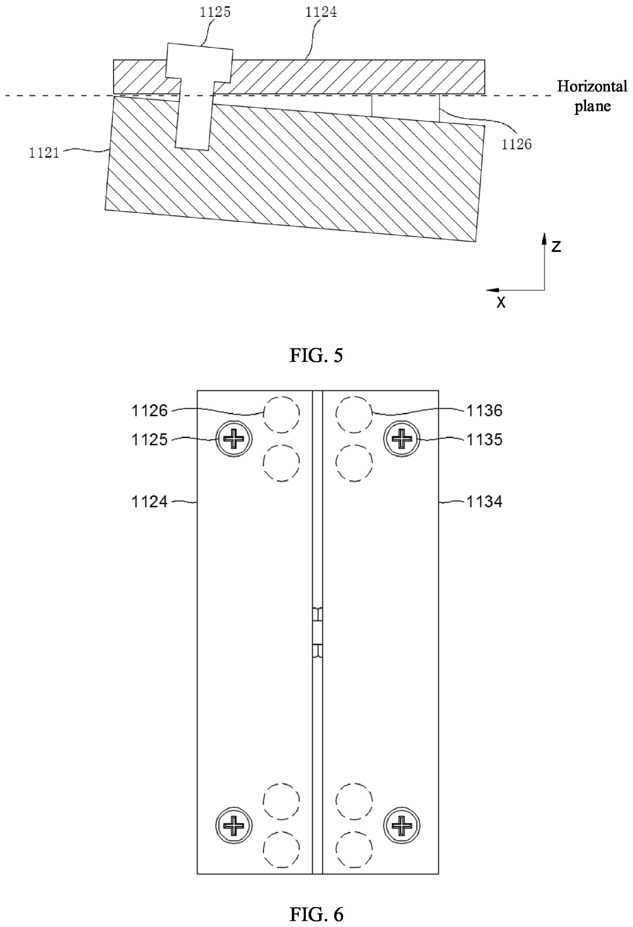

Refer to FIG. 4 and FIG. 5. FIG. 4 is a diagram of a structure of a door plate of a hinge mechanism according to an embodiment of this application, and FIG. 5 is a diagram of a sectional structure of a door plate of a hinge mechanism according to an embodiment of this application. For coordinate directions in the following figures, a direction indicated by a y-axis represents a first direction, a direction indicated by an x-axis represents a second direction, and a direction indicated by a z-axis represents a third direction. The second direction is perpendicular to the first direction, and the second direction is perpendicular to a thickness direction of the hinge mechanism. Specifically, the second direction may be an extension direction of a plane on which the flexible display is located. The third direction is perpendicular to the first direction and the second direction. In embodiments of this application, with reference to FIG. 4 and FIG. 5, the first door plate 1124 is provided with at least two first limiting holes, the at least two first limiting holes are spaced apart in the first direction, a first connecting piece 1125 is disposed in the first limiting hole, and the first connecting piece 1125 is fastened to the first arc arm 1121, to fasten the first door plate 1124 to the first arc arm 1121. During specific implementation, the first connecting piece 1125 may be a connecting piece such as a screw or a pin. At least two first limiting layers 1126 are disposed between the first door plate 1124 and the first arc arm 1121, the at least two first limiting layers 1126 are spaced apart in the first direction, the first limiting layer 1126 and the first limiting hole are spaced apart in the second direction, and the first limiting layer 1126 is fastened to the first door plate 1124 and the first arc arm 1121. During specific implementation, the first limiting layer 1126 may be a laminated structure formed through coagulation of glue, and a projection of the first limiting layer 1126 in the third direction may be in a plurality of regular or irregular shapes such as a circle, an ellipse, or a polygon. This is not limited in this application.

In the hinge mechanism provided in embodiments of this application, the first door plate 1124 and the first arc arm 1121 are fastened by using a plurality of first connecting pieces 1125 and a plurality of first limiting layers 1126. The plurality of first connecting pieces 1125 are spaced apart in the first direction, so that degrees of freedom of the first door plate 1124 in the first direction and the second direction can be limited. The first limiting layer 1126 and the first limiting hole are spaced apart in the second direction, so that a degree of freedom of the first door plate 1124 in the third direction can be limited. In this way, the first door plate 1124 can be locked, to avoid displacement of the first door plate 1124 relative to the first arc arm 1121 in a process of unfolding or folding the entire device. In an assembly phase of the hinge mechanism, the first connecting piece 1125 limits the degrees of freedom of the first door plate 1124 in the first direction and the second direction, and the first door plate 1124 has a specific degree of freedom in the third direction, or the first door plate 1124 has a specific degree of freedom of rotation. When the hinge mechanism is in a flattened state, an included angle between the first door plate 1124 and a horizontal plane may be changed through matching with first limiting layers 1126 having different thicknesses, thereby overcoming an included angle difference between the horizontal plane and a surface of the first arc arm 1121 for mounting the first door plate 1124, and reducing the included angle between the first door plate 1124 and the horizontal plane when the entire device is in the flattened state, so that the included angle between the first door plate 1124 and the horizontal plane is equal to or close to zero, and screen light and shadow quality of a folding axis area of the electronic device is improved.

During specific implementation, the first limiting layer 1126 may be formed in a dispensing manner, and may be adaptively formed based on space between the first door plate 1124 and the first arc arm 1121. In a glue curing process, a planar pressure maintaining and curing process may be used, and the angle difference between the horizontal plane and the surface of the first arc arm 1121 for mounting the first door plate 1124 is absorbed by using a feature that a dispensing thickness can be relatively adjusted based on pressure maintaining, to ensure that the first door plate 1124 is horizontal.

For a procedure of a mounting process of the first door plate 1124, refer to the following: Dispensing is performed at a designed position of the first limiting layer 1126 on the surface of the first arc arm 1121 for mounting the first door plate 1124, to maintain glue fluidity; the first door plate 1124 is connected to the first arc arm 1121 through the first connecting piece 1125, to pre-fasten the first door plate 1124; and pressure maintaining is performed on the first door plate 1124 by using the horizontal plane to ensure that the first door plate 1124 is horizontal, and the first limiting layer 1126 is formed after glue curing. The first limiting layer 1126 and the first connecting piece 1125 jointly ensure that the first door plate 1124 is securely connected to the first arc arm 1121.

During specific implementation, the first limiting layer 1126 and the first limiting hole may be staggered in the first direction, to stably limit the degrees of freedom of the first door plate 1124 in the first direction and the second direction, so that a position of the first door plate 1124 is stable. A part of the at least two first limiting holes is disposed close to an end of the first door plate 1124 in the first direction, and the other part of the first limiting holes is disposed close to the other end of the first door plate 1124 in the first direction, that is, a plurality of first limiting holes are separately arranged at two ends of the first door plate 1124 in the first direction, so that the degrees of freedom of the first door plate 1124 in the first direction and the second direction can be stably limited. Similarly, a part of the at least two first limiting layers 1126 is disposed close to the end of the first door plate 1124 in the first direction, and the other part of the first limiting layers 1126 is disposed close to the other end of the first door plate 1124 in the first direction, so that the degrees of freedom of the first door plate 1124 in the first direction and the second direction can also be stably limited.

FIG. 4 shows an example of a manner of fastening a door plate. As shown in FIG. 4, the first door plate 1124 is provided with four first limiting holes, two of the four first limiting holes are disposed close to the end of the first door plate 1124 in the first direction, and the other two first limiting holes are disposed close to the other end of the first door plate 1124 in the first direction. Two first limiting layers 1126 are disposed between the first door plate 1124 and the first arc arm 1121, one of the two first limiting layers 1126 is disposed close to the end of the first door plate 1124 in the first direction, and the other one first limiting layer 1126 is disposed close to the other end of the first door plate 1124 in the first direction. In this way, two first limiting holes and one first limiting layer 1126 are disposed at the end of the first door plate 1124 in the first direction, and two first limiting holes and one first limiting layer 1126 are also disposed at the other end of the first door plate 1124 in the first direction, so that the first door plate 1124 can be fastened and horizontally disposed by using a relatively small quantity of first connecting pieces 1125 and first limiting layers 1126.

During specific implementation, for two first limiting holes and one first limiting layer 1126 that are disposed close to a same end of the first door plate 1124 in the first direction, the first limiting layer 1126 is located between the two first limiting holes in the first direction, and the first limiting layer 1126 and the two first limiting holes may form a layout similar to a triangle, so that a fastened connection between the first door plate 1124 and the first arc arm 1121 can be stably maintained. The first limiting holes and the first limiting layers 1126 at the two ends of the first door plate 1124 in the first direction may be symmetrically disposed, to facilitate processing and assembly of the first door plate 1124.

Refer to FIG. 6. FIG. 6 is a diagram of a manner of fastening a door plate of a hinge mechanism according to an embodiment of this application. FIG. 6 shows an example in which the first door plate 1124 is provided with two first limiting holes, one of the two first limiting holes is disposed close to the end of the first door plate 1124 in the first direction, and the other one first limiting hole is disposed close to the other end of the first door plate 1124 in the first direction. Four first limiting layers 1126 are disposed between the first door plate 1124 and the first arc arm 1121, two of the four first limiting layers 1126 are disposed close to the end of the first door plate 1124 in the first direction, and the other two first limiting layers 1126 are disposed close to the other end of the first door plate 1124 in the first direction. In this way, one first limiting hole and two first limiting layers 1126 are disposed at the end of the first door plate 1124 in the first direction, and one first limiting hole and two first limiting layers 1126 are also disposed at the other end of the first door plate 1124 in the first direction, so that the first door plate 1124 can be fastened and horizontally disposed by using a relatively small quantity of first connecting pieces 1125 and first limiting layers 1126.

During specific implementation, for one first limiting hole and two first limiting layers 1126 that are disposed close to a same end of the first door plate 1124 in the first direction, the first limiting hole is located between the two first limiting layers 1126 in the first direction, and the first limiting hole and the two first limiting layers 1126 may form a layout similar to a triangle, so that a fastened connection between the first door plate 1124 and the first arc arm 1121 can be stably maintained. The first limiting holes and the first limiting layers 1126 at the two ends of the first door plate 1124 in the first direction may be symmetrically disposed.

In practical application, the entire electronic device tends to be light and thin, and the door plate becomes thinner accordingly. However, the door plate is relatively long, overall flatness of the door plate is difficult to maintain, the door plate is prone to deformation, and a flexible printed circuit (flexible printed circuit, FPC) and the like arranged below the door plate may apply an upward force to the door plate, causing the door plate to partially tilt upward. These factors affect an included angle between the entire door plate or a part of the door plate and the horizontal plane when the entire device is in a flattened state. Consequently, the included angle between the door plate and the horizontal plane has greater uncertainty, affecting screen light and shadow quality.

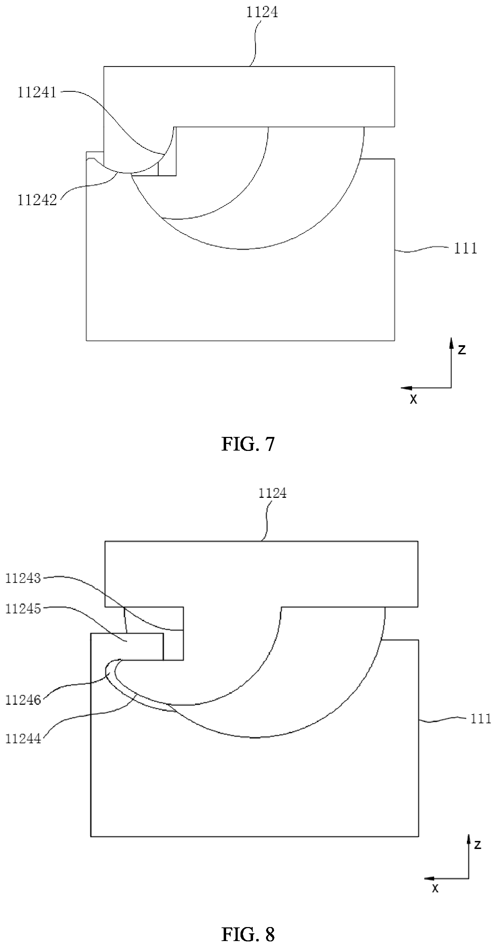

Refer to FIG. 7. FIG. 7 is a diagram of a structure of a door plate of a hinge mechanism according to an embodiment of this application. To overcome the foregoing problem, a first protrusion 11241 is disposed on the surface that is of the first door plate 1124 and that is away from the flexible display, and the first protrusion 11241 and the first limiting hole are spaced apart in the first direction. In fit with the first protrusion 11241, a first support surface 11242 is provided on a surface that is of the main shaft 111 and that faces the flexible display, and the first support surface 11242 corresponds to the first protrusion 11241 in the third direction. When the electronic device is unfolded to a flattened state, an end that is of the first protrusion 11241 and that is away from the first door plate 1124 abuts against the first support surface 11242. Disposing the first protrusion 11241 can expand a control area of the included angle between the first door plate 1124 and the horizontal plane. In an area that is of the first door plate 1124 and that is not constrained by the first connecting piece 1125 and the first limiting layer 1126, the first protrusion 11241 is disposed to increase limiting on the first door plate 1124 in the third direction, and prop up the first door plate 1124, so as to prevent the first door plate 1124 from collapsing due to factors such as deformation of the first door plate 1124 and the gravity, and ensure that the first door plate 1124 is horizontal.

During specific implementation, the first protrusion 11241 may be located between two adjacent first limiting holes in the first direction. For example, when a plurality of first limiting holes are separately arranged at the two ends of the first door plate 1124 in the first direction, the first protrusion 11241 may be disposed in a middle area of the first door plate 1124 in the first direction, that is, disposed in a middle area of the first door plate 1124 in a length direction. The end that is of the first protrusion 11241 and that is away from the first door plate 1124 may be in a planar shape. Correspondingly, the first support surface 11242 is also in a planar shape. Fitting between the first protrusion 11241 and the first support surface 11242 is relatively simple and reliable. Alternatively, the end that is of the first protrusion 11241 and that is away from the first door plate 1124 may be in a curved shape. Correspondingly, the first support surface 11242 is also in a curved shape. After the first protrusion 11241 and the first support surface 11242 fit each other, a position of the first protrusion 11241 is relatively stable, and fitting between the first protrusion 11241 and the first support surface 11242 is relatively reliable. During actual disposing, a groove may be provided on the surface that is of the main shaft 111 and that faces the flexible display, and a bottom surface of the groove may be used as the first support surface 11242. In this way, position stability after the first protrusion 11241 fits the first support surface 11242 can be improved.

Refer to FIG. 8. FIG. 8 is a diagram of a structure of a door plate of another hinge mechanism according to an embodiment of this application. A third protrusion 11243 is disposed on the surface that is of the first door plate 1124 and that is away from the flexible display, the third protrusion 11243 and the first limiting hole are spaced apart in the first direction, a first limiting claw 11244 is disposed at an end that is of the third protrusion 11243 and that is away from the first door plate 1124, and the first limiting claw 11244 extends in the second direction. A first limiting wall 11245 is disposed on the surface that is of the main shaft 111 and that faces the flexible display, the first limiting wall 11245 corresponds to the first limiting claw 11244 in the third direction, the first limiting wall 11245 extends in the second direction, and the first limiting wall 11245 and the main shaft 111 form a first limiting slot 11246 having a first opening. In a process of unfolding the electronic device, the first limiting claw 11244 extends into the first limiting slot 11246 through the first opening. When the electronic device is unfolded to the flattened state, the first limiting claw 11244 abuts against the first limiting wall 11245. Disposing the first limiting claw 11244 and the first limiting slot 11246 can expand a control area of the included angle between the first door plate 1124 and the horizontal plane. In an area that is of the first door plate 1124 and that is not constrained by the first connecting piece 1125 and the first limiting layer 1126, the first limiting claw 11244 and the first limiting slot 11246 are disposed to increase limiting on the first door plate 1124 in the third direction, and hook the first door plate 1124, so as to prevent the first door plate 1124 from tilting upward due to factors such as deformation of the first door plate 1124 and an upward force applied by another component, and ensure that the first door plate 1124 is horizontal.

During specific implementation, the third protrusion 11243 may be located between two adjacent first limiting holes in the first direction. For example, when a plurality of first limiting holes are separately arranged at the two ends of the first door plate 1124 in the first direction, the third protrusion 11243 may be disposed in a middle area of the first door plate 1124 in the first direction, that is, disposed in a middle area of the first door plate 1124 in a length direction. A surface that is of the first limiting claw 11244 and that abuts against the first limiting wall 11245 may be in a planar shape. Correspondingly, a surface that is of the first limiting wall 11245 and that abuts against the first limiting claw 11244 is also in a planar shape. Fitting between the first limiting claw 11244 and the first limiting wall 11245 is relatively simple and reliable. Alternatively, a surface that is of the first limiting claw 11244 and that abuts against the first limiting wall 11245 may be in a curved shape. Correspondingly, a surface that is of the first limiting wall 11245 and that abuts against the first limiting claw 11244 is also in a curved shape. After the first limiting claw 11244 and the first limiting wall 11245 fit each other, a position of the first limiting claw 11244 is relatively stable, and fitting between the first limiting claw 11244 and the first limiting wall 11245 is relatively reliable. During actual disposing, the third protrusion 11243 and the first protrusion 11241 are spaced apart in the first direction.

In the foregoing specific implementation, the first door plate 1124 can be prevented from partially collapsing or tilting upward, an overall flatness of the first door plate 1124 can be ensured in a length direction of the first door plate 1124, and consistency of the included angle between the first door plate 1124 and the horizontal plane can be ensured. This helps improve screen light and shadow quality. It may be understood that, the first protrusion 11241 and the first support surface 11242 form a fitting structure, and the first limiting claw 11244 and the first limiting slot 11246 form a fitting structure. The two fitting structures may coexist, or only one of the two fitting structures may exist. This may be specifically disposed according to an actual requirement.

As described above, the second rotation module 113 and the first rotation module 112 may be separately disposed on two sides of the main shaft 111. During specific implementation, refer to the foregoing figures again. The second rotation module 113 may include a second arc arm 1131, a second support arm 1132, a second housing support 1133, and a second door plate 1134. The second door plate 1134 may be configured to support the flexible display, and is fastened to the flexible display. The second arc arm 1131 and the second support arm 1132 may be disposed on a surface that is of the second door plate 1134 and that is away from the flexible display. The second arc arm 1131 and the second support arm 1132 may be distributed in the length direction of the hinge mechanism, and are rotatably connected to the main shaft 111. The second housing support 1133 may be located on a surface that is of the second arc arm 1131 and that is away from the second door plate 1134 and a surface that is of the second support arm 1132 and that is away from the second door plate 1134. The second housing support 1133 may be configured to be fastened to the second housing, to implement a fastened connection between the second housing and the second rotation module 113. The second housing support 1133 may be rotatably connected to the second arc arm 1131 and slidably connected to the second support arm 1132. In a process of unfolding or folding the electronic device, the second housing support 1133 rotates synchronously with the second housing, to drive the second arc arm 1131 and the second support arm 1132 to rotate synchronously around the main shaft 111. In addition, the second door plate 1134 may be fastened to the second arc arm 1131, and the second door plate 1134 may rotate synchronously with the second arc arm 1131. Thus, in a rotation process of the second housing support 1133, the second door plate 1134 can also rotate according to a specific track, to provide flat support for the flexible display when the electronic device is in an unfolded state, and provide specific screen accommodating space for the flexible display when the electronic device is in a folded state.

During specific implementation, the second door plate 1134 may be provided with at least two second limiting holes, the at least two second limiting holes are spaced apart in the first direction, a second connecting piece 1135 is disposed in the second limiting hole, the second connecting piece 1135 is fastened to the second arc arm to fasten the second door plate 1134 to the second arc arm, at least two second limiting layers 1136 may be disposed between the second door plate 1134 and the second arc arm, the at least two second limiting layers 1136 are spaced apart in the first direction, the second limiting layer 1136 and the second limiting hole are spaced apart in the second direction, and the second limiting layer 1136 is fastened to the second door plate 1134 and the second arc arm.

During specific implementation, the second limiting layer 1136 and the second limiting hole may be staggered in the first direction. A part of the at least two second limiting holes may be disposed close to an end of the second door plate 1134 in the first direction, and the other part of the second limiting holes may be disposed close to the other end of the second door plate 1134 in the first direction; and a part of the at least two second limiting layers 1136 may be disposed close to the end of the second door plate 1134 in the first direction, and the other part of the second limiting layers 1136 may be disposed close to the other end of the second door plate 1134 in the first direction.

In a possible implementation, the second door plate 1134 is provided with four second limiting holes, two of the four second limiting holes are disposed close to the end of the second door plate 1134 in the first direction, and the other two second limiting holes are disposed close to the other end of the second door plate 1134 in the first direction; and two second limiting layers 1136 are disposed between the second door plate 1134 and the second arc arm, one of the two second limiting layers 1136 is disposed close to the end of the second door plate 1134 in the first direction, and the other one second limiting layer 1136 is disposed close to the other end of the second door plate 1134 in the first direction. For two second limiting holes and one second limiting layer 1136 that are disposed close to a same end of the second door plate 1134 in the first direction, the second limiting layer 1136 is located between the two second limiting holes in the first direction.

In another possible implementation, the second door plate 1134 is provided with two second limiting holes, one of the two second limiting holes is disposed close to the end of the second door plate 1134 in the first direction, and the other one second limiting hole is disposed close to the other end of the second door plate 1134 in the first direction; and four second limiting layers 1136 are disposed between the second door plate 1134 and the second arc arm, two of the four second limiting layers 1136 are disposed close to the end of the second door plate 1134 in the first direction, and the other two second limiting layers 1136 are disposed close to the other end of the second door plate 1134 in the first direction. For one second limiting hole and two second limiting layers 1136 that are disposed close to a same end of the second door plate 1134 in the first direction, the second limiting hole is located between the two second limiting layers 1136 in the first direction.

To improve overall flatness of the door plate and ensure consistency of the included angle between the door plate and the horizontal plane, a second protrusion may be disposed on the surface that is of the second door plate 1134 and that is away from the flexible display, the second protrusion and the second limiting hole are spaced apart in the first direction, a second support surface is disposed on the surface that is of the main shaft 111 and that faces the flexible display, the second support surface corresponds to the second protrusion in the third direction, and when the electronic device is unfolded to the flattened state, an end that is of the second protrusion and that is away from the second door plate 1134 abuts against the second support surface. The second protrusion may be located between two adjacent second limiting holes in the first direction.

A fourth protrusion may be disposed on the surface that is of the second door plate 1134 and that is away from the flexible display, the fourth protrusion and the second limiting hole are spaced apart in the first direction, a second limiting claw is disposed at an end that is of the fourth protrusion and that is away from the second door plate 1134, the second limiting claw extends in the second direction, a second limiting wall may be disposed on the surface that is of the main shaft 111 and that faces the flexible display, the second limiting wall corresponds to the second limiting claw in the third direction, the second limiting wall extends in the second direction, the second limiting wall and the main shaft 111 form a second limiting slot having a second opening, the second limiting claw may extend into the second limiting slot through the second opening in the process of unfolding the electronic device, and when the electronic device is unfolded to the flattened state, the second limiting claw abuts against the second limiting wall. The fourth protrusion may be located between two adjacent second limiting holes in the first direction.

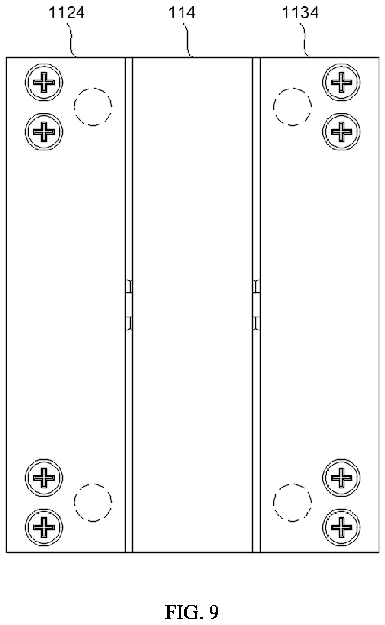

Refer to FIG. 9. FIG. 9 is a diagram of a structure of a hinge mechanism according to an embodiment of this application. In a possible specific implementation, a third door plate 114 may be disposed on the surface that is of the main shaft and that faces the flexible display, and the third door plate 114 is also configured to support the flexible display. The third door plate 114 is located between the first rotation module and the second rotation module. When the electronic device is unfolded to the flattened state, the third door plate 114, the first door plate 1124, and the second door plate 1134 are on a same plane. The third door plate 114 may be fastened to the main shaft by using a connecting piece such as a screw, or the third door plate 114 may be bonded to the main shaft to implement a fastened connection. When the electronic device is unfolded or folded, an intermediate door plate does not rotate.

It may be understood that various numbers in embodiments of this application are merely used for differentiation for ease of description, and are not used to limit the scope of embodiments of this application. Sequence numbers of the foregoing processes do not mean a sequence of execution. The sequence of execution of the processes should be determined according to functions and internal logic of the processes.

The foregoing descriptions are merely specific implementations of this application. However, the protection scope of this application is not limited thereto. Any change or replacement readily figured out by a person skilled in the art within the technical scope disclosed in this application shall fall within the protection scope of this application.

## Claims

1. A hinge mechanism, used in a foldable electronic device, wherein the hinge mechanism is disposed opposite to a foldable part of a flexible display of the electronic device, the electronic device is unfolded or folded via the hinge mechanism, the hinge mechanism comprises a first rotation module, a second rotation module, and a main shaft, and the first rotation module and the second rotation module are separately disposed on two opposite sides of the main shaft;
the first rotation module comprises a first door plate and a first arc arm, the first door plate is configured to support the flexible display, at least a part of the first arc arm is disposed on a surface that is of the first door plate and that is away from the flexible display, the first arc arm is rotatably connected to the main shaft, the first door plate is provided with at least two first limiting holes, the at least two first limiting holes are spaced apart in a first direction, a first connecting piece is disposed in the first limiting hole, the first connecting piece is fastened to the first arc arm to fasten the first door plate to the first arc arm, at least two first limiting layers are disposed between the first door plate and the first arc arm, the at least two first limiting layers are spaced apart in the first direction, the first limiting layer and the first limiting hole are spaced apart in a second direction, the first limiting layer is fastened to the first door plate and the first arc arm, the first direction is an axial direction of the hinge mechanism, the second direction is perpendicular to the first direction, and the second direction is perpendicular to a thickness direction of the hinge mechanism; and
the second rotation module comprises a second door plate and a second arc arm, the second door plate is configured to support the flexible display, at least a part of the second arc arm is disposed on a surface that is of the second door plate and that is away from the flexible display, the second arc arm is rotatably connected to the main shaft, the second door plate is provided with at least two second limiting holes, the at least two second limiting holes are spaced apart in the first direction, a second connecting piece is disposed in the second limiting hole, the second connecting piece is fastened to the second arc arm to fasten the second door plate to the second arc arm, at least two second limiting layers are disposed between the second door plate and the second arc arm, the at least two second limiting layers are spaced apart in the first direction, the second limiting layer and the second limiting hole are spaced apart in the second direction, and the second limiting layer is fastened to the second door plate and the second arc arm.

2. The hinge mechanism according to claim 1, wherein the first limiting layer and the first limiting hole are staggered in the first direction; and
the second limiting layer and the second limiting hole are staggered in the first direction.

3. The hinge mechanism according to claim 1 or 2, wherein a part of the at least two first limiting holes is disposed close to an end of the first door plate in the first direction, and the other part of the first limiting holes is disposed close to the other end of the first door plate in the first direction; and a part of the at least two first limiting layers is disposed close to the end of the first door plate in the first direction, and the other part of the first limiting layers is disposed close to the other end of the first door plate in the first direction; and
a part of the at least two second limiting holes is disposed close to an end of the second door plate in the first direction, and the other part of the second limiting holes is disposed close to the other end of the second door plate in the first direction; and a part of the at least two second limiting layers is disposed close to the end of the second door plate in the first direction, and the other part of the second limiting layers is disposed close to the other end of the second door plate in the first direction.

4. The hinge mechanism according to claim 3, wherein the first door plate is provided with four first limiting holes, two of the four first limiting holes are disposed close to the end of the first door plate in the first direction, and the other two first limiting holes are disposed close to the other end of the first door plate in the first direction; and two first limiting layers are disposed between the first door plate and the first arc arm, one of the two first limiting layers is disposed close to the end of the first door plate in the first direction, and the other one first limiting layer is disposed close to the other end of the first door plate in the first direction; and
the second door plate is provided with four second limiting holes, two of the four second limiting holes are disposed close to the end of the second door plate in the first direction, and the other two second limiting holes are disposed close to the other end of the second door plate in the first direction; and two second limiting layers are disposed between the second door plate and the second arc arm, one of the two second limiting layers is disposed close to the end of the second door plate in the first direction, and the other one second limiting layer is disposed close to the other end of the second door plate in the first direction.

5. The hinge mechanism according to claim 4, wherein for two first limiting holes and one first limiting layer that are disposed close to a same end of the first door plate in the first direction, the first limiting layer is located between the two first limiting holes in the first direction; and
for two second limiting holes and one second limiting layer that are disposed close to a same end of the second door plate in the first direction, the second limiting layer is located between the two second limiting holes in the first direction.

6. The hinge mechanism according to claim 3, wherein the first door plate is provided with two first limiting holes, one of the two first limiting holes is disposed close to the end of the first door plate in the first direction, and the other one first limiting hole is disposed close to the other end of the first door plate in the first direction; and four first limiting layers are disposed between the first door plate and the first arc arm, two of the four first limiting layers are disposed close to the end of the first door plate in the first direction, and the other two first limiting layers are disposed close to the other end of the first door plate in the first direction; and
the second door plate is provided with two second limiting holes, one of the two second limiting holes is disposed close to the end of the second door plate in the first direction, and the other one second limiting hole is disposed close to the other end of the second door plate in the first direction; and four second limiting layers are disposed between the second door plate and the second arc arm, two of the four second limiting layers are disposed close to the end of the second door plate in the first direction, and the other two second limiting layers are disposed close to the other end of the second door plate in the first direction.

7. The hinge mechanism according to claim 6, wherein for one first limiting hole and two first limiting layers that are disposed close to a same end of the first door plate in the first direction, the first limiting hole is located between the two first limiting layers in the first direction; and
for one second limiting hole and two second limiting layers that are disposed close to a same end of the second door plate in the first direction, the second limiting hole is located between the two second limiting layers in the first direction.

8. The hinge mechanism according to any one of claims 1 to 7, wherein a first protrusion is disposed on the surface that is of the first door plate and that is away from the flexible display, the first protrusion and the first limiting hole are spaced apart in the first direction, a first support surface is disposed on a surface that is of the main shaft and that faces the flexible display, the first support surface corresponds to the first protrusion in a third direction, the third direction is perpendicular to the first direction and the second direction, and when the electronic device is unfolded to a flattened state, an end that is of the first protrusion and that is away from the first door plate abuts against the first support surface; and
a second protrusion is disposed on the surface that is of the second door plate and that is away from the flexible display, the second protrusion and the second limiting hole are spaced apart in the first direction, a second support surface is disposed on the surface that is of the main shaft and that faces the flexible display, the second support surface corresponds to the second protrusion in the third direction, and when the electronic device is unfolded to the flattened state, an end that is of the second protrusion and that is away from the second door plate abuts against the second support surface.

9. The hinge mechanism according to claim 8, wherein the first protrusion is located between two adjacent first limiting holes in the first direction; and
the second protrusion is located between two adjacent second limiting holes in the first direction.

10. The hinge mechanism according to any one of claims 1 to 9, wherein a third protrusion is disposed on the surface that is of the first door plate and that is away from the flexible display, the third protrusion and the first limiting hole are spaced apart in the first direction, a first limiting claw is disposed at an end that is of the third protrusion and that is away from the first door plate, the first limiting claw extends in the second direction, a first limiting wall is disposed on the surface that is of the main shaft and that faces the flexible display, the first limiting wall corresponds to the first limiting claw in the third direction, the third direction is perpendicular to the first direction and the second direction, the first limiting wall extends in the second direction, the first limiting wall and the main shaft form a first limiting slot having a first opening, the first limiting claw extends into the first limiting slot through the first opening in a process of unfolding the electronic device, and when the electronic device is unfolded to the flattened state, the first limiting claw abuts against the first limiting wall; and
a fourth protrusion is disposed on the surface that is of the second door plate and that is away from the flexible display, the fourth protrusion and the second limiting hole are spaced apart in the first direction, a second limiting claw is disposed at an end that is of the fourth protrusion and that is away from the second door plate, the second limiting claw extends in the second direction, a second limiting wall is disposed on the surface that is of the main shaft and that faces the flexible display, the second limiting wall corresponds to the second limiting claw in the third direction, the second limiting wall extends in the second direction, the second limiting wall and the main shaft form a second limiting slot having a second opening, the second limiting claw extends into the second limiting slot through the second opening in the process of unfolding the electronic device, and when the electronic device is unfolded to the flattened state, the second limiting claw abuts against the second limiting wall.

11. The hinge mechanism according to claim 10, wherein the third protrusion is located between two adjacent first limiting holes in the first direction; and
the fourth protrusion is located between two adjacent second limiting holes in the first direction.

12. The hinge mechanism according to any one of claims 1 to 11, wherein a third door plate is disposed on the surface that is of the main shaft and that faces the flexible display, the third door plate is configured to support the flexible display, the third door plate is located between the first rotation module and the second rotation module, and when the electronic device is unfolded to the flattened state, the third door plate, the first door plate, and the second door plate are located on a same plane.

13. An electronic device, comprising a first housing, a second housing, a flexible display, and the hinge mechanism according to any one of claims 1 to 12, wherein
the first housing and the second housing are separately disposed on two opposite sides of the hinge mechanism, the first housing is fastened to the first rotation module, and the second housing is fastened to the second rotation module; and
the flexible display continuously covers the first housing, the second housing, and the hinge mechanism, and the flexible display is fastened to the first housing and the second housing.
